(19) Europäisches Patentamt
European Patent Office
Office européen des brevets

(11) EP 4 207 267 A1

(12) EUROPEAN PATENT APPLICATION
published in accordance with Art. 153(4) EPC

(43) Date of publication:
**05.07.2023 Bulletin 2023/27**

(21) Application number: **21875605.4**

(22) Date of filing: **28.09.2021**

(51) International Patent Classification (IPC):
***H01L 23/15*** (2006.01) ***B32B 5/18*** (2006.01)
***B32B 9/00*** (2006.01) ***B32B 9/04*** (2006.01)
***B32B 15/04*** (2006.01) ***B32B 27/04*** (2006.01)
***C04B 35/5835*** (2006.01) ***C04B 38/00*** (2006.01)
***C04B 41/83*** (2006.01) ***H01L 23/12*** (2006.01)
***H01L 23/14*** (2006.01)

(52) Cooperative Patent Classification (CPC):
**B32B 5/18; B32B 9/00; B32B 9/04; B32B 15/04; B32B 27/04; C04B 35/583; C04B 38/00; C04B 41/83; H01L 23/12; H01L 23/14; H01L 23/15**

(86) International application number:
**PCT/JP2021/035601**

(87) International publication number:
**WO 2022/071304 (07.04.2022 Gazette 2022/14)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **29.09.2020 JP 2020163283**

(71) Applicant: **Denka Company Limited**
**Tokyo 103-8338 (JP)**

(72) Inventors:
- **WAKUDA, Yusuke**
**Tokyo 103-8338 (JP)**
- **MINAKATA, Yoshitaka**
**Tokyo 103-8338 (JP)**
- **SAKAGUCHI, Shinya**
**Tokyo 103-8338 (JP)**
- **YAMAGUCHI, Tomoya**
**Tokyo 103-8338 (JP)**
- **IKARASHI, Koki**
**Tokyo 103-8338 (JP)**
- **NISHIMURA, Koji**
**Tokyo 103-8338 (JP)**

(74) Representative: **Hoffmann Eitle**
**Patent- und Rechtsanwälte PartmbB**
**Arabellastraße 30**
**81925 München (DE)**

# (54) COMPOSITE SHEET, LAMINATE, AND EVALUATION METHOD FOR ESTIMATING ADHESIVENESS OF COMPOSITE SHEET

(57) One aspect of the present disclosure provides a composite sheet including a porous sintered ceramic component having a thickness of less than 2 mm and a resin filled into pores of the sintered ceramic component, wherein the resin is a semi-cured product of a resin composition including a compound having a cyanate group and the content of triazine rings in the resin is 0.6 to 4.0 mass%.

*Fig.1*

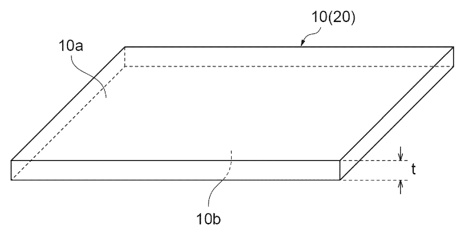




Processed by Luminess, 75001 PARIS (FR)

## Description

### Technical Field

The present disclosure relates to a composite sheet, a laminate, and an evaluation method for estimating adhesiveness of a composite sheet.

### Background Art

Components such as power devices, transistors, thyristors, and CPUs are required to efficiently radiate heat generated during use. In response to such demands, conventionally, it is possible to increase the thermal conductivity of an insulating layer of a printed wiring board on which an electronic component is mounted or attach an electronic component or a printed wiring board to a heat sink via a thermal interface material having electrical insulation. For such an insulating layer and thermal interface material, a composite composed of a resin and a ceramic such as boron nitride is used as a heat radiation member.

As such a composite, a composite obtained by combining a porous sintered ceramic component (for example, a sintered boron nitride component) and a resin by impregnating the sintered ceramic component with the resin has been studied (for example, refer to Patent Literature 1). In addition, in a laminate including a metal circuit and a resin-impregnated sintered boron nitride component, bringing primary particles constituting the sintered boron nitride component and the metal circuit into direct contact with each other to reduce the thermal resistance of the laminate and improve heat radiation has also been studied (for example, refer to Patent Literature 2).

### Citation List

### Patent Literature

[Patent Literature 1] PCT International Publication No. WO2014/196496
[Patent Literature 2] Japanese Unexamined Patent Publication No. 2016-103611

### Summary of Invention

### Technical Problem

Along with high integration of circuits in semiconductor devices and the like in recent years, it has been required to reduce the size of components. In addition, along with this, the contact area between members is becoming smaller. Under such circumstances, in order to secure reliability, it is considered necessary to improve adhesiveness between members made of different materials.

Here, an object of the present disclosure is to provide a composite sheet that can be easily miniaturized and has excellent adhesiveness. An object of the present disclosure is to provide a laminate that has excellent adhesiveness even when miniaturized using such a composite sheet. An object of the present disclosure is to provide an evaluation method for estimating adhesiveness of a composite sheet.

### Solution to Problem

When a composite sheet is adhered to other members, voids may be formed at the interface between the composite sheet and other members, and the inventors conducted detailed studies and found that voids may be formed at the interface between the composite sheet and other members due to curing shrinkage associated with thermosetting of a resin part constituting the composite sheet, and in order to reduce curing shrinkage, it is desirable to adjust the state of the resin to an appropriate curing state in advance in the state of the composite sheet, and moreover, the curing state of the resin part correlates with the content of triazine rings formed by trimerization of cyanate groups, and according to a composite sheet in which the content of triazine rings is adjusted to be within a predetermined range, during adhesion to other members, it is possible to achieve both improvement in adhesiveness according to flowing out of the resin and reduction in curing shrinkage associated with thermosetting at a high level. The present disclosure is made based on this finding.

One aspect of the present disclosure is to provide a composite sheet including a porous sintered ceramic component having a thickness of less than 2 mm and a resin filled into pores of the sintered ceramic component, wherein

the resin is a semi-cured product of a resin composition including a compound having a cyanate group, and the content of triazine rings in the resin is 0.6 to 4.0 mass%.

The composite sheet is in a curing state in which the content of triazine rings in the resin is within a predetermined range, and when it is adhered to other members under heat and pressure, the resin is appropriately exuded, the adhesiveness can be improved, and since the curing shrinkage is small, the generation of voids at the interface is reduced and a decrease in adhesiveness is also minimized. According to such actions, it is possible to provide a laminate having excellent adhesiveness using the composite sheet.

One aspect of the present disclosure provides a composite sheet including a porous sintered ceramic component having a thickness of less than 2 mm and a resin filled into pores of the sintered ceramic component, wherein the resin is a semi-cured product of a resin composition including a compound having a cyanate group, and a value (ratio) obtained by dividing a peak intensity (an integral value of peaks in the frequency range) at 1,533 to 1,565 $cm^{-1}$ corresponding to a triazine ring when an infrared absorption intensity corresponding to the resin is measured by a total reflection measurement method (ATR method) in infrared absorption spectroscopy (IR) by a peak intensity at 1,498 to 1,526 $cm^{-1}$ (an integral value of peaks in the frequency range) is 0.200 to 0.800.

The composite sheet is in a predetermined curing state in which the value obtained by dividing a peak intensity in a specific frequency range corresponding to a triazine ring in the resin by a peak intensity at 1,498 to 1,526 $cm^{-1}$ is within a predetermined range. Therefore, when the composite sheet is adhered to other members under heat and pressure, the resin is appropriately exuded, and the adhesiveness can be improved, and since the curing shrinkage is small, the generation of voids at the interface is reduced, and a decrease in adhesiveness is also minimized. According to such actions, it is possible to provide a laminate having excellent adhesiveness using the composite sheet.

The filling rate of the resin may be 85 volume% or more. Since the filling rate of the resin is sufficiently high, during adhesion to other members under heat and pressure, the resin component can sufficiently exude from the interior of the composite sheet, and it is possible to further improve adhesiveness. In addition, when the amount of the resin filled is not excessively large, a resin layer is formed between other members, and it is possible to minimize deterioration of heat radiation.

One aspect of the present disclosure provides a laminate in which the above composite sheet and a metal sheet are laminated.

Since the laminate is produced using the above composite sheet, it has excellent adhesiveness.

One aspect of the present disclosure provides an evaluation method for estimating adhesiveness of a composite sheet including a porous sintered ceramic component having a thickness of less than 2 mm and a resin filled into pores of the sintered ceramic component, including a step of measuring an infrared absorption intensity of the resin by an ATR method and a step of estimating the adhesiveness of the composite sheet using the value of the infrared absorption intensity.

In the evaluation method, an infrared absorption intensity in a resin part constituting a composite sheet is measured, a curing state of the resin part is determined based on the obtained result, and adhesiveness of the composite sheet which is a measurement subject adhered to other members is estimated, and it is possible to evaluate adhesiveness of a composite sheet by non-destructive inspection.

## Advantageous Effects of Invention

According to the present disclosure, it is possible to provide a composite sheet that can be easily miniaturized and has excellent adhesiveness. According to the present disclosure, it is possible to provide a laminate that has excellent adhesiveness even when miniaturized using such a composite sheet. According to the present disclosure, it is possible to provide an evaluation method for estimating adhesiveness of a composite sheet.

## Brief Description of Drawings

FIG. 1 is a perspective view showing an example of a composite sheet.
FIG. 2 is a cross-sectional view showing an example of a laminate.

## Description of Embodiments

Hereinafter, embodiments of the present disclosure will be described with reference to the drawings in some cases. However, the following embodiments are only examples for describing the present invention, and the present invention is not limited to the following content. In the description, components which are the same or components having the same functions are denoted with the same reference numerals and redundant descriptions will be omitted in some

cases. In addition, positional relationships such as above, below, left and right are based on the positional relationship shown in the drawings unless otherwise specified. In addition, the dimensional ratios of respective components are not limited to the illustrated ratios.

Unless otherwise specified, materials exemplified in this specification may be used alone or two or more thereof may be used in combination. When there are a plurality of substances corresponding to components in a composition, the content of the components in the composition means a total amount of the plurality of substances in the composition unless otherwise specified.

A composite sheet according to one embodiment includes a porous sintered ceramic component having a thickness of less than 2 mm and a resin filled into pores of the sintered ceramic component. The resin is a semi-cured product of a resin composition including a compound having a cyanate group, and contains a triazine ring formed by trimerization of a cyanate group. In one aspect of the composite sheet, the content of triazine rings in the resin is 0.6 to 4.0 mass%. In addition, in another aspect, a value (ratio) obtained by dividing a peak intensity (an integral value of peaks in the frequency range) at 1,533 to 1,565 $cm^{-1}$ corresponding to a triazine ring when an infrared absorption intensity corresponding to the resin is measured by a total reflection measurement method (ATR method) in infrared absorption spectroscopy (IR) by a peak intensity at 1,498 to 1,526 $cm^{-1}$ (an integral value of peaks in the frequency range) is 0.200 to 0.800. A composite sheet in which the content of the triazine rings is within the above range or the ratio is within the above range has practically sufficient adhesiveness.

FIG. 1 is a perspective view showing an example of a composite sheet 10. The composite sheet 10 includes a porous sintered ceramic component 20 having a thickness t of less than 2 mm and a resin filled into pores of the sintered ceramic component 20. The sintered ceramic component 20 may be, for example, a sintered nitride component. The sintered nitride component contains nitride particles formed by sintering nitride primary particles and pores.

A "resin" in the present disclosure is a semi-cured product (B stage) of a resin composition containing a main agent and a curing agent. The semi-cured product is a product in which the curing reaction of the resin composition has partially proceeded. Therefore, the resin includes a thermosetting resin produced by the reaction of the main agent and the curing agent in the resin composition. The semi-cured product may contain monomers of a main agent and a curing agent in addition to the thermosetting resin as a resin component. The fact that the resin contained in the composite sheet is a semi-cured product (B stage) before being completely cured (C stage) can be confirmed with, for example, a differential scanning calorimeter.

The semi-cured product of the resin composition contains a triazine ring formed by trimerization of a compound having a cyanate group. The semi-cured product of the resin composition may additionally include, for example, at least one structural unit selected from the group consisting of a structural unit derived from a bismaleimide group and a structural unit derived from an epoxy group. When the semi-cured product of the resin composition further includes a structural unit derived from a bismaleimide group and a structural unit derived from an epoxy group, it is possible to easily produce a composite sheet and it is possible to further improve adhesiveness between the composite sheet and other members such as a metal sheet.

Examples of structural units derived from a bismaleimide group include a structure represented by the following Formula (1). Examples of structural units derived from an epoxy group include a structure represented by the following General Formula (2). These structural units can be detected using infrared absorption spectroscopy (IR). Proton nuclear magnetic resonance spectroscopy ($^1$H-NMR) and carbon-13 nuclear magnetic resonance spectroscopy ($^{13}$C-NMR) can be used for detection. The above structural units may be detected by any of IR, $^1$H-NMR and $^{13}$C-NMR.

[Chem. 1]

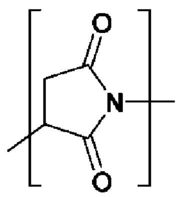

(1)

[Chem. 2]

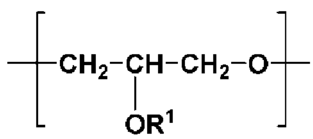

(2)

In General Formula (2), $R^1$ represents a hydrogen atom or another functional group. Examples of other functional groups include an alkyl group.

The semi-cured product may contain at least one selected from the group consisting of a cyanate resin, a bismaleimide resin and an epoxy resin as a thermosetting resin. The cyanate resin may contain, for example, an oxazoline ring in addition to the triazine ring, depending on the type of monomers constituting the main agent and the type of the curing agent. The semi-cured product may contain, for example, a phenolic resin, a melamine resin, a urea resin, and an alkyd resin, in addition to the thermosetting resin.

The semi-cured product may contain at least one curing agent selected from the group consisting of a phosphine-based curing agent and an imidazole-based curing agent. The semi-cured product may be a cured product formed by curing the polymerizable compound (for example, a compound having a cyanate group, a compound having an epoxy group, etc.) contained in the resin composition with these curing agents.

The content of triazine rings in the resin based on a total mass of the resin is 0.6 to 4.0 mass%. The lower limit value of the content of triazine rings in the resin based on a total mass of the resin may be, for example, 0.8 mass% or more, or 0.9 mass% or more. When the lower limit value of the content of triazine rings is within the above range, shrinkage associated with the curing reaction of the resin due to heat and pressure is more sufficiently minimized, and the generation of voids at the interface between the composite sheet and other members can be further reduced. The upper limit value of the content of triazine rings in the resin based on a total mass of the resin may be, for example, 3.5 mass% or less, or 3.0 mass% or less. When the upper limit value of the content of triazine rings is within the above range, the resin can be appropriately softened and exuded when the composite sheet and other members are adhered, and thus it is possible to further improve the adhesiveness. Here, the content of triazine rings in the resin can be adjusted by controlling the degree of curing of the resin composition containing a main agent and a curing agent, and for example, it can be adjusted by the heating temperature, the heating time, the amount of the curing agent added and the like in the curing step of semi-curing the resin composition in the production of the composite sheet.

In this specification, the content of triazine rings is a value measured by $^{13}C$-NMR and is represented by mass% of the structure itself with respect to the total mass of the resin.

The content of triazine rings in the resin corresponds to the infrared absorption intensity in the resin, and it is possible to focus on a specific ratio obtained using the infrared absorption intensity. A value (value (ratio) represented by [peak intensity at 1,533 to 1,565 $cm^{-1}$]/[peak intensity at 1,498 to 1,526 $cm^{-1}$]) obtained by dividing a peak intensity at 1,533 to 1,565 $cm^{-1}$ corresponding to a triazine ring when an infrared absorption intensity corresponding to the resin is measured by a total reflection measurement method (ATR method) in infrared absorption spectroscopy (IR) by a peak intensity at 1,498 to 1,526 $cm^{-1}$ is 0.200 to 0.800. The lower limit value of the ratio may be, for example, 0.240 or more or 0.300 or more. When the lower limit value of the ratio is within the above range, shrinkage associated with the curing reaction of the resin due to heat and pressure is more sufficiently minimized, and the generation of voids at the interface between the composite sheet and other members can be further reduced. The upper limit value of the ratio may be, for example, 0.750 or less or 0.700 or less. When the upper limit value of the ratio is within the above range, the resin can be appropriately softened and exuded when the composite sheet and other members are adhered, and thus it is possible to further improve the adhesiveness. Here, the peak intensity in a specific frequency range corresponding to the triazine ring can be adjusted by controlling the degree of curing of the resin composition containing a main agent and a curing agent, and for example, it can be adjusted by the heating temperature, the heating time, the amount of the curing agent added and the like in the curing step of semi-curing the resin composition in the production of the composite sheet.

In this specification, the infrared absorption intensity is a value determined by measurement based on a total reflection measurement method (ATR method) in infrared absorption spectroscopy (IR), and can be measured in a non-destructive manner. More specifically, it is measured by the method described in examples in this specification. Here, infrared absorption corresponding to the triazine ring is observed near a frequency of 1,563 $cm^{-1}$. In the frequency range of 1,498 to 1,526 $cm^{-1}$, infrared absorption corresponding to a structure of a monocyclic aromatic ring is observed. Here, the bottom of the peak corresponding to the triazine ring may extend beyond the range of 1,533 to 1,565 $cm^{-1}$, but even in such a case, a peak intensity (integral value) in a range of 1,533 to 1,565 $cm^{-1}$ is used.

The filling rate of the resin in the composite sheet 10 may be, for example, 85 volume% or more. When the filling rate of the resin is within the above range, the amount of the resin component exuded can sufficiently increase during adhesion to other members under heat and pressure, and the composite sheet of the present embodiment has better adhesiveness. The lower limit value of the filling rate of the resin may be, for example, 88 volume% or more, and in order to further improve adhesiveness, it may be 90 volume% or more, or 92 volume% or more.

The volume proportion of the resin in the composite sheet 10 based on a total volume of the composite sheet 10 may be 30 to 60 volume% or 35 to 55 volume%. The volume proportion of ceramic particles constituting the sintered ceramic component 20 in the composite sheet 10 based on a total volume of the composite sheet 10 may be 40 to 70 volume% or 45 to 65 volume%. The composite sheet 10 having such a volume proportion can achieve both excellent adhesiveness and strength at a high level.

The average pore size of pores of the sintered ceramic component 20 may be, for example, 5 μm or less, 4

μm or less, or 3.5 μm or less. Since the size of pores of such a sintered ceramic component 20 is small, it is possible to sufficiently increase the contact area between ceramic particles. Therefore, it is possible to increase thermal conductivity. The average pore size of pores of the sintered ceramic component 20 may be 0.5 μm or more, 1 μm or more or 1.5 μm or more. Since such a sintered ceramic component 20 can be sufficiently deformed by pressing during adhesion, it is possible to increase the amount of the resin component exuded. Therefore, it is possible to further improve adhesiveness.

The average pore size of pores of the sintered ceramic component 20 can be measured by the following procedure. First, the composite sheet 10 is heated to remove the resin. Then, using a mercury porosimeter, the pore size distribution is obtained when the sintered ceramic component 20 is pressed while increasing the pressure from 0.0042 MPa to 206.8 MPa. When the horizontal axis represents the pore size and the vertical axis represents the cumulative pore volume, the pore size when the cumulative pore volume reaches 50% of the total pore volume is defined as the average pore size. A mercury porosimeter (commercially available from Shimadzu Corporation) can be used.

The porosity of the sintered ceramic component 20, that is, the volume proportion of pores in the sintered ceramic component 20 may be 30 to 65 volume% or 35 to 55 volume%. If the porosity is too large, the strength of the sintered ceramic component tends to decrease. On the other hand, if the porosity is too small, the amount of the resin exuded tends to decrease when the composite sheet 10 is adhered to other members.

A bulk density [B(kg/m$^3$)] is calculated from the volume and the mass of the sintered ceramic component 20, and the porosity can be obtained from the bulk density and a theoretical density [A(kg/m$^3$)] of a ceramic according to the following Formula (1). In an example in which the sintered ceramic component 20 is a sintered nitride component, at least one selected from the group consisting of boron nitride, aluminum nitride, and silicon nitride may be contained as a nitride. In the case of boron nitride, the theoretical density A is 2,280 kg/m$^3$. In the case of aluminum nitride, the theoretical density A is 3,260 kg/m$^3$. In the case of silicon nitride, the theoretical density A is 3,170 kg/m$^3$.

$$\text{Porosity (volume\%)}=[1-(B/A)]\times 100 \ \ldots \ \text{Formula (1)}$$

When the sintered ceramic component 20 is a sintered boron nitride component, the bulk density B may be 800 to 1,500 kg/m$^3$ or 1,000 to 1,400 kg/m$^3$. If the bulk density B is too small, the strength of the sintered ceramic component 20 tends to decrease. On the other hand, if the bulk density B is too large, the amount of the resin filled decreases, and the amount of the resin exuded tends to decrease when the composite sheet 10 is adhered to other members.

The thickness t of the sintered ceramic component 20 may be less than 2 mm or less than 1.6 mm. When the sintered ceramic component 20 has such a thickness, the pores can be more easily filled with the resin and a composite sheet having better adhesiveness can be easily prepared. Therefore, it is possible to reduce the size of the composite sheet 10 and improve adhesiveness of the composite sheet 10. Such a composite sheet 10 is suitably used as a component of a semiconductor device. In consideration of ease of production of the sintered ceramic component 20, the thickness t of the sintered ceramic component 20 may be 0.1 mm or more or 0.2 mm or more.

The thickness of the composite sheet 10 may be the same as the thickness t of the sintered ceramic component 20 or may be larger than the thickness t of the sintered ceramic component 20. The thickness of the composite sheet 10 may be less than 2 mm or less than 1.6 mm. The thickness of the composite sheet 10 may be 0.1 mm or more or 0.2 mm or more. The thickness of the composite sheet 10 is measured in a direction perpendicular to main surfaces 10a and 10b. When the thickness of the composite sheet 10 is not constant, the thicknesses are measured at 10 arbitrarily selected locations, and the average value thereof should be within the above range. Even if the thickness of the sintered ceramic component 20 is not constant, the thicknesses are measured at 10 arbitrarily selected locations, and the average value thereof is defined as the thickness t. The size of the main surfaces 10a and 10b of the composite sheet 10 is not particularly limited, and may be, for example, 500 mm$^2$ or more, 800 mm$^2$ or more, or 1,000 mm$^2$ or more.

The main surface 10a and the main surface 10b of the composite sheet 10 are preferably not cut surfaces. Therefore, it is possible to reduce the proportion of the sintered ceramic component 20 exposed on the main surface 10a and the main surface 10b, and it is possible to sufficiently increase the resin coverage. As a result, it is possible to improve adhesiveness with other members laminated on the main surface 10a and the main surface 10b.

The main surface 10a and the main surface 10b of the composite sheet 10 of the present embodiment are quadrangular, but the present invention is not limited to such a shape. For example, the shape of the main surface may be a polygon other than a quadrangle or may be a circle. In addition, a shape with chamfered corners or a shape with a notched part may be used. In addition, the main surface may have a through-hole that penetrates in the thickness direction.

FIG. 2 is a cross-sectional view of an example of a laminate cut in the thickness direction. A laminate 100 includes the composite sheet 10, a metal sheet 30 adhered to the main surface 10a of the composite sheet 10, and a metal sheet 40 adhered to the main surface 10b of the composite sheet 10. The metal sheets 30 and 40 may be a metal

plate or a metal foil. Examples of materials of the metal sheets 30 and 40 include aluminum and copper. The materials and thicknesses of the metal sheets 30 and 40 may be the same as or different from each other. In addition, it is not essential to provide both of the metal sheets 30 and 40, and in a modified example of the laminate 100, only one of the metal sheets 30 and 40 may be provided.

The laminate 100 may have a resin layer between the composite sheet 10 and the metal sheets 30 and 40 without departing from the spirit of the present disclosure. The resin layer may be formed by curing the resin exuded from the composite sheet 10. The composite sheet 10 and the metal sheets 30 and 40 in the laminate 100 are sufficiently firmly adhered with the exuded resin so that the adhesiveness is excellent. Since such a laminate is thin and has excellent adhesiveness and heat radiation, for example, it can be suitably used as a heat radiation member for a semiconductor device and the like.

A method for producing a composite sheet according to one embodiment includes a sintering step of preparing a porous sintered ceramic component, an impregnating step of impregnating a resin composition into pores of a sintered ceramic component having a thickness of less than 2 mm to obtain a resin-impregnated component, and a curing step of heating the resin-impregnated component and semi-curing the resin composition filled into the pores. Here, in the production method in the present embodiment, the resin composition that is cured in advance (for example, semi-cured) may be impregnated into the sintered ceramic component, and in this case, the curing step may not be provided. In this regard, the curing step is an optional step. Hereinafter, an example in which the sintered ceramic component is a sintered nitride component will be described.

In this specification, "semi-cured state" (also referred to as a B stage) refers to a state in which the component is additionally cured by a subsequent curing treatment. Temporary press-bonding with other members such as a metal sheet is performed using the semi-cured component, and heating is then performed so that the composite sheet and the metal sheet may be adhered. When the semi-cured product is additionally subjected to a curing treatment, it becomes "completely cured" (also referred to as a C stage).

The raw material powder used in the sintering step contains a nitride. The nitride contained in the raw material powder may include, for example, at least one nitride selected from the group consisting of boron nitride, aluminum nitride, and silicon nitride. When boron nitride is contained, the boron nitride may be an amorphous boron nitride or a hexagonal boron nitride. When a sintered boron nitride component is prepared as the sintered ceramic component 20, as the raw material powder, for example, amorphous boron nitride powder particles having an average particle size of 0.5 to 10 $\mu$m or hexagonal boron nitride powder particles having an average particle size of 3.0 to 40 $\mu$m can be used.

In the sintering step, a formulation containing nitride powder may be molded and sintered to obtain a sintered nitride component. Molding may be performed by uniaxial pressing or a cold isostatic press (CIP) method. A sintering additive may be added to obtain a formulation before molding. Examples of sintering additives include metal oxides such as yttrium oxide, aluminum oxide and magnesium oxide, alkali metal carbonates such as lithium carbonate and sodium carbonate, and boric acid. When a sintering additive is added, the amount of the sintering additive added, for example, with respect to a total amount of 100 parts by mass of the nitride and the sintering additive, may be, for example, 0.01 parts by mass or more, or 0.1 parts by mass or more. The amount of the sintering additive added with respect to a total amount of 100 parts by mass of the nitride and the sintering additive may be, for example, 20 parts by mass or less, 15 parts by mass or less, or 10 parts by mass or less. When the amount of the sintering additive added is set to be within the above range, it becomes easier to adjust the average pore size of the sintered nitride component to be within the range to be described below.

The formulation may be formed into a sheet-like molded product by, for example, a doctor blade method. The molding method is not particularly limited, and press molding may be performed using a mold to form a molded product. The molding pressure may be, for example, 5 to 350 MPa. The shape of the molded product may be a sheet shape having a thickness of less than 2 mm. If a sintered nitride component is produced using such a sheet-like molded product, it is possible to produce a sheet-like composite sheet having a thickness of less than 2 mm without cutting the sintered nitride component. In addition, compared to when the block-like sintered nitride component is cut to form a sheet, the material loss due to processing can be reduced by forming a sheet from the stage of the molded product. Therefore, it is possible to produce composite sheets with a high yield.

The sintering temperature in the sintering step may be, for example, 1,600°C or higher or 1,700°C or higher. The sintering temperature may be, for example, 2,200°C or lower or 2,000°C or lower. The sintering time may be, for example, 1 hour or more or 30 hours or less. The atmosphere during sintering may be, for example, an inert gas atmosphere such as nitrogen, helium, and argon.

For sintering, for example, a batch type furnace or a continuous type furnace can be used. Examples of batch type furnaces include a muffle furnace, a tube furnace, and an atmospheric furnace. Examples of continuous type furnaces include a rotary kiln, a screw conveyor furnace, a tunnel furnace, a belt furnace, a pusher furnace, and a large continuous furnace. Accordingly, a sintered nitride component can be obtained. The sintered nitride component may have a block shape.

When the sintered nitride component has a block shape, a cutting step of cutting the clock so that the thickness

is less than 2 mm is performed. In the cutting step, the sintered nitride component is cut using, for example, a wire-saw. Examples of wire-saws include a multi-cut wire-saw. According to such a cutting step, for example, it is possible to obtain a sheet-like sintered nitride component having a thickness of less than 2 mm. The sintered nitride component obtained in this manner has a cut surface.

When the sintered nitride component is subjected to the cutting step, fine cracks may occur on the cut surface. On the other hand, since the composite sheet obtained without performing the cutting step on the sintered nitride component does not have a cut surface, it is possible to sufficiently reduce fine cracks. Therefore, the composite sheet obtained without performing the cutting step on the sintered nitride component can sufficiently improve insulation and thermal conductivity while maintaining sufficiently high strength. That is, the composite sheet has excellent reliability as a member of an electronic component and the like. In addition, when processing such as cutting is performed, the material loss occurs. Therefore, the composite sheet having no cut surface of the sintered nitride component can reduce material loss. Thereby, it is possible to improve the yield of the sintered nitride component and the composite sheet.

In the impregnating step, a resin composition is impregnated into pores of the sintered ceramic component 20 having a thickness of less than 2 mm to obtain a resin-impregnated component. The curing rate of the resin impregnated in this case is 20 to 70%. Since the sintered nitride component (the sintered ceramic component 20) has a sheet shape having a thickness of less than 2 mm, the resin composition is easily impregnated thereinto. In addition, if the curing rate when the resin composition is impregnated into the sintered nitride component is set to be within a predetermined range, it is suitable for impregnation, the filling rate of the resin can be sufficiently increased, and the curing rate of the resin in the obtained composite sheet can be easily adjusted.

For example, when the temperature T1 at which the resin composition is impregnated into the sintered nitride component is the temperature T2 at which the resin composition is semi-cured, it may be equal to or higher than the temperature T3 (=T2-20°C) and lower than the temperature T4 (=T2+20°C). The temperature T3 may be, for example, 80 to 140°C. Impregnation of the resin composition into the sintered nitride component may be performed under pressurization, under a reduced pressure, or under atmospheric pressure. The impregnating method is not particularly limited, and the sintered nitride component may be immersed in the resin composition and the resin composition may be applied to the surface of the sintered nitride component for impregnation.

The resin composition may be cured in advance (for example, semi-cured), and the heating temperature when curing of the resin composition proceeds by heating may be, for example, 80 to 130°C or 90 to 120°. The heating time when curing of the resin composition proceeds by heating may be, for example, 4 to 12 hours or 5 to 11 hours. When the heating time is lengthened, trimerization of the compound having a cyanate group in the resin composition can further proceed, and it is possible to improve the content of triazine rings in the resin.

When the curing rate of the resin composition is within an appropriate range, the resin can be sufficiently filled into the sintered nitride component. The filling rate of the resin may be, for example, 85 to 97 volume%, the lower limit value of the filling rate of the resin may be, for example, 88 volume% or more, 90 volume% or more, or 92 volume% or more.

The impregnating step may be performed under any condition of a reduced-pressure condition, a pressurized condition and an atmospheric pressure condition and may be performed under a combination of two or more of impregnation under a reduced-pressure condition, impregnation under a pressurized condition, and impregnation under atmospheric pressure. The pressure in the impregnation device when the impregnating step is performed under a reduced-pressure condition may be, for example, 1,000 Pa or less, 500 Pa or less, 100 Pa or less, 50 Pa or less, or 20 Pa or less. The pressure in the impregnation device when the impregnating step is performed under a pressurized condition may be, for example, 1 MPa or more, 3 MPa or more, 10 MPa or more, or 30 MPa or more.

When the pore size of pores in the sintered nitride component is adjusted, it is also possible to promote impregnation of the resin composition according to a capillary phenomenon. In this regard, the average pore size of the sintered nitride component may be 0.5 to 5 $\mu$m or 1 to 4 $\mu$m.

As the resin composition, for example, one that becomes the resin exemplified in the above description of the composite sheet according to a curing or semi-curing reaction can be used. The resin composition may contain a solvent. The viscosity of the resin composition may be adjusted by changing the amount of the solvent added, or the viscosity of the resin composition may be adjusted by partially causing the curing reaction to proceed. Examples of solvents include aliphatic alcohols such as ethanol and isopropanol, ether alcohols such as 2-methoxyethanol, 1-methoxyethanol, 2-ethoxyethanol, 1-ethoxy-2-propanol, 2-butoxyethanol, 2-(2-methoxyethoxy)ethanol, 2-(2-ethoxyethoxy)ethanol, and 2-(2-butoxyethoxy)ethanol, glycol ethers such as ethylene glycol monomethyl ether, and ethylene glycol monobutyl ether, ketones such as acetone, methyl ethyl ketone, methyl isobutyl ketone, and diisobutyl ketone, and hydrocarbons such as toluene and xylene. These may be used alone or two or more thereof may be used in combination.

The resin composition is thermosetting and contains a compound having a cyanate group and a curing agent. The resin composition may further contain at least one compound selected from the group consisting of a compound having a bismaleimide group and a compound having an epoxy group.

Examples of compounds having a cyanate group include dimethylmethylenebis(1,4-phenylene)biscyanate, and bis(4-cyanatophenyl)methane. Dimethylmethylenebis(1,4-phenylene)biscyanate is commercially available, for example,

as TACN (product name, commercially available from Mitsubishi Gas Chemical Company, Inc.).

Examples of compounds having a bismaleimide group include N,N'-[(1-methylethylidene)bis[(p-phenylene)oxy(p-phenylene)]]bismal eimide, and 4,4'-diphenylmethane bismaleimide. N,N'-[(1-methylethylidene)bis[(p-phenylene)oxy(p-phenylene)]]bismal eimide is commercially available as, for example, BMI-80 (product name, commercially available from K·I Chemical Industry Co., Ltd.).

Examples of compounds having an epoxy group include a bisphenol F type epoxy resin, a bisphenol A type epoxy resin, a biphenyl type epoxy resin, and a multifunctional epoxy resin. For example, 1,6-bis(2,3-epoxypropan-1-yloxy)naphthalene commercially available as HP-4032D (product name, commercially available from DIC) may be used.

The curing agent may contain a phosphine-based curing agent and an imidazole-based curing agent, and preferably contains a phosphine-based curing agent. The phosphine-based curing agent can promote a triazine formation reaction by trimerization of a compound having a cyanate group or a cyanate resin.

Examples of phosphine-based curing agents include tetraphenylphosphonium tetra-p-tolylborate and tetraphenylphosphonium tetraphenylborate. Tetraphenylphosphonium tetra-p-tolylborate is commercially available as, for example, TPP-MK (product name, commercially available from Hokko Chemical Industry Co., Ltd.).

The imidazole-based curing agent generates oxazoline and promotes a curing reaction of a compound having an epoxy group or an epoxy resin. Examples of imidazole-based curing agents include 1-(1-cyanomethyl)-2-ethyl-4-methyl-1H-imidazole, and 2-ethyl-4-methylimidazole. 1-(1-cyanomethyl)-2-ethyl-4-methyl-1H-imidazole is commercially available as, for example, 2E4MZ-CN (product name, commercially available from Shikoku Chemical Corporation).

The content of the phosphine-based curing agent with respect to a total amount of 100 parts by mass of the compound having a cyanate group, the compound having a bismaleimide group and the compound having an epoxy group may be, for example, 5 parts by mass or less, 4 parts by mass or less, or 3 parts by mass or less. The content of the phosphine-based curing agent with respect to a total amount of 100 parts by mass of the compound having a cyanate group, the compound having a bismaleimide group and the compound having an epoxy group may be, for example, 0.1 parts by mass or more, or 0.5 parts by mass or more. When the content of the phosphine-based curing agent is within the above range, it is easy to prepare the resin-impregnated component, and it is possible to further shorten the time taken for the composite sheet cut out from the resin-impregnated component to be adhered to other members.

The content of the imidazole-based curing agent with respect to a total amount of 100 parts by mass of the compound having a cyanate group, the compound having a bismaleimide group and the compound having an epoxy group may be, for example, 0.1 parts by mass or less, 0.05 parts by mass or less, or 0.03 parts by mass or less. The content of the imidazole-based curing agent with respect to a total amount of 100 parts by mass of the compound having a cyanate group, the compound having a bismaleimide group and the compound having an epoxy group may be, for example, 0.001 parts by mass or more, or 0.005 parts by mass or more. When the content of the imidazole-based curing agent is within the above range, it is easy to prepare the resin-impregnated component and it is possible to further shorten the time taken for the composite sheet cut out from the resin-impregnated component to be adhered to an adherend used.

The resin composition may contain components other than the main agent and the curing agent. Other components include, for example, other resins such as a phenolic resin, a melamine resin, a urea resin, and an alkyd resin, and may further include a silane coupling agent, a leveling agent, an antifoaming agent, a surface adjusting agent, and a wetting and dispersing agent. The content of these other components based on a total amount of the resin composition may be, for example, 20 mass% or less, 10 mass% or less, or 5 mass% or less.

After the impregnating step, as necessary, a curing step of semi-curing the resin composition impregnated into pores may be provided. In the curing step, according to the type of the resin composition (or a curing agent added as necessary), the curing rate of the resin composition is adjusted by heating and/or light emission. If the resin composition is insufficiently cured in the impregnating step, it is possible to semi-cure the resin composition in this step.

In the curing step, the heating temperature when the resin composition is semi-cured by heating may be, for example, 80 to 130°C. The semi-cured product obtained by semi-curing the resin composition may contain, as the resin component, at least one thermosetting resin selected from the group consisting of a cyanate resin, a bismaleimide resin and an epoxy resin, and a curing agent. The semi-cured product may contain, as the resin component, for example, other resins such as a phenolic resin, a melamine resin, a urea resin, and an alkyd resin, and a component derived from a silane coupling agent, a leveling agent, an antifoaming agent, a surface adjusting agent, and a wetting and dispersing agent.

The composite sheet obtained in this manner has, for example, a thickness of 2 mm or less. Therefore, the composite sheet is thin and lightweight, and when it is used as a component of a semiconductor device and the like, it is possible to reduce the size and weight of the device. In addition, since the resin is sufficiently filled into pores of the sintered nitride component, not only adhesiveness but also thermal conductivity and insulation are excellent. In addition, in the above production method, it is possible to produce a composite sheet without cutting the sintered nitride component. Therefore, it is possible to produce a composite sheet having excellent reliability with a high yield. Here, in addition to forming a laminate by laminating a metal sheet on a composite sheet, the composite sheet can be directly used as a

heat radiation member.

A method for producing a laminate according to one embodiment includes a laminating step of laminating a composite sheet and a metal sheet, heating and pressing the laminate. The composite sheet can be produced by the above production method. The metal sheet may be a metal plate or a metal foil.

In the laminating step, a metal sheet is disposed on the main surface of the composite sheet. With the main surfaces of the composite sheet and the metal sheet in contact with each other, pressurization is performed in a direction in which the main surfaces face each other and heating is performed. Here, pressurization and heating need not necessarily be performed at the same time, and heating may be performed after pressurization and press-bonding. The pressurization pressure may be, for example, 2 to 10 MPa. When the temperature at which the resin composition is semi-cured is set as T2, the heating temperature T5 in this case may be T2+20°C or higher or T2+40°C or higher. Therefore, the resin composition exuded from the composite sheet can be cured at the interface between the composite sheet and the metal sheet, and the two can be firmly adhered. In order to prevent decomposition of the cured product, the heating temperature T5 may be T2+150°C or lower or T2+100°C or lower.

The laminate obtained in this manner can be used for production of a semiconductor device and the like. A semiconductor element may be provided on one metal sheet. The other metal sheet may be bonded to a cooling fin.

An evaluation method for estimating adhesiveness of a composite sheet according to one embodiment is an evaluation method for estimating adhesiveness of a composite sheet including a porous sintered ceramic component having a thickness of less than 2 mm and a resin filled into pores of the sintered ceramic component, including a step of measuring an infrared absorption intensity of the resin by an ATR method and a step of estimating the adhesiveness of the composite sheet using the value of the infrared absorption intensity.

The step of estimating the adhesiveness of the composite sheet may be a step of estimating the adhesiveness of the composite sheet based on the value obtained by dividing a peak intensity at 1,533 to 1,565 $cm^{-1}$ corresponding to a triazine ring in an infrared absorption spectrum of the resin by a peak intensity at 1,498 to 1,526 $cm^{-1}$. For example, it can be said that, when the ratio is within a range of 0.200 to 0.800, the composite sheet to be evaluated has practically sufficient adhesiveness.

While several embodiments have been described above, the same descriptions can be applied to common configurations. In addition, the present disclosure is not limited to the above embodiments.

[Examples]

The content of the present disclosure will be described in more detail with reference to examples and comparative examples, but the present disclosure is not limited to the following examples.

(Example 1)

<Production of sintered nitride component (sintered ceramic component)>

100 parts by mass of orthoboric acid (commercially available from Nippon Denko Co., Ltd.), and 35 parts by mass of acetylene black (product name: HS100, commercially available from Denka Co., Ltd.) were mixed using a Henschel mixer. The obtained mixture was filled into a graphite crucible and heated at 2,200°C for 5 hours in an argon atmosphere in an arc furnace to obtain a mass boron carbide ($B_4C$). The obtained mass was coarsely pulverized with a jaw crusher to obtain a coarse powder. The coarse powder was additionally pulverized with a ball mill having silicon carbide balls (φ10 mm) to obtain a pulverized powder.

The prepared pulverized powder was filled into a boron nitride crucible. Then, using a resistance heating furnace, heating was performed for 10 hours in a nitrogen gas atmosphere under conditions of 2,000°C and 0.85 MPa. Thus, a fired product containing boron carbonitride ($B_4CN_4$) was obtained.

A powder-like boric acid and calcium carbonate were added to prepare a sintering additive. In preparation, 50.0 parts by mass of calcium carbonate was added with respect 100 parts by mass of boric acid. In this case, regarding the atomic ratio of boron and calcium, the proportion of calcium was 17.5 atom% with respect to 100 atom% of boron. 20 parts by mass of the sintering additive was added with respect to 100 parts by mass of the fired product, and mixed using a Henschel mixer to prepare a powder-like formulation.

The formulation was pressed using a powder press machine at 150 MPa for 30 seconds to obtain a sheet-like (length×width×thickness=50 mm×50 mm×0.30 mm) molded product. The molded product was put into a boron nitride container and introduced into a batch-type high-frequency furnace. In the batch-type high-frequency furnace, heating was performed under conditions of atmospheric pressure, a nitrogen flow rate of 5 L/min, and 2,000°C for 5 hours. Then, the sintered boron nitride component was removed from the boron nitride container. Accordingly, a sheet-like (square prism-shaped) sintered boron nitride component was obtained. The thickness of the sintered boron nitride component was 0.31 mm.

<Measurement of average pore size>

For the obtained sintered boron nitride component, the pore volume distribution was measured while increasing the pressure from 0.0042 MPa to 206.8 MPa using a mercury porosimeter (device name: Autopore IV9500, commercially available from Shimadzu Corporation). The pore size at which the cumulative pore volume reached 50% of the total pore volume was defined as the "average pore size." The results are shown in Table 1.

<Preparation of resin>

0.5 parts by mass of a commercially available curing agent (product name: Achmex H-84B commercially available from The Nippon Synthetic Chemical Industry Co., Ltd.) was added to 10 parts by mass of a commercially available bismaleimide (BMI-80 (product name, commercially available from K·I Chemical Industry Co., Ltd.), 29.5 parts by mass of an epoxy resin (product name: Epikote 807, commercially available from Mitsubishi Chemical Corporation), and 60 parts by mass of a commercially available cyanate resin (product name: TACN, commercially available from Mitsubishi Gas Chemical Company, Inc.) to prepare a resin composition. The prepared resin composition was heated at 120°C for 5 hours and thus a resin, which is a semi-cured product of the resin composition, was prepared.

<Measurement of content of triazine ring in resin (semi-cured product)>

The content of triazine rings in the prepared resin was measured using carbon-13 nuclear magnetic resonance spectroscopy ($^{13}$C-NMR). For measurement, an NMR device (BrukerAVANCE NEO) and a probe (CryoProbe) were used. Measurement conditions included a cumulative number of measurements of 256.

<Measurement of infrared absorption intensity corresponding to triazine ring in resin (semi-cured product)>

The infrared absorption intensity corresponding to the triazine ring in the prepared resin was measured by the total reflection measurement method (ATR method) in infrared absorption spectroscopy (IR). For measurement, a single reflection ATR accessory (commercially available from SensIR, Dura Scope), and a Fourier transform infrared spectrometer (product name: Spectrum One, commercially available from PerkinElmer Co., Ltd.) were used. The measurement was performed by the ATR method. Measurement conditions included a resolution of 4 $cm^{-1}$ and a cumulative number of measurements of 16.

<Production of composite sheet>

The obtained resin that was kept at 120°C was added dropwise to the main surface of the sintered boron nitride component heated to 160°C. The resin composition added dropwise to the main surface of the sintered boron nitride component under atmospheric pressure was applied and spread using a rubber spatula, the resin was applied to and spread on the entire main surface to obtain a resin-impregnated component. Accordingly, a square prism-shaped composite sheet (length×width×thickness=length×width×thickness=50 mm×50 mm×0.31 mm) was produced.

<Measurement of filling rate of resin (semi-cured product)>

The filling rate of the resin contained in the composite sheet was obtained by the following Formula (2). The results are as shown in Table 1.

filling rate (volume%) of resin in composite sheet={(bulk density of composite sheet-bulk density of sintered boron nitride component)/(theoretical density of composite sheet-bulk density of sintered boron nitride component)}×100 ...Formula (2)

The bulk density of the sintered boron nitride component and the composite sheet was obtained according to "Methods of measuring density and specific gravity by geometric measurement" in JIS Z 8807: 2012 based on the volume calculated from the length (measured with a vernier caliper) of each side of the sintered boron nitride component or the composite sheet and the mass of the sintered boron nitride component or the composite sheet measured with an

electronic scale (refer to Item 9 of JIS Z 8807: 2012). The theoretical density of the composite sheet was obtained by the following Formula (3).

$$\text{theoretical density of composite sheet} = \text{true density of sintered boron nitride component} + \text{true density of resin} \times (1 - \text{bulk density of sintered boron nitride component} / \text{true density of boron nitride}) \quad \ldots (3)$$

The true density of the sintered boron nitride component and the resin was obtained according to "Methods of measuring density and specific gravity by gas replacement method" in JIS Z 8807: 2012 based on the volume and mass of the sintered boron nitride component and the resin measured using a dry automatic density meter (refer to Formulae (14) to (17) in Item 11 of JIS Z 8807: 2012).

<Production of laminate>

The above composite sheet (length×width×thickness=50 mm×20 mm×0.31 mm) was disposed between a sheet-like copper foil (length×width×thickness=100 mm×20 mm×0.035 mm) and a sheet-like copper plate (length×width×thickness=100 mm×20 mm×1 mm), and a laminate including the copper foil, the composite sheet and the copper plate in this order was produced. The laminate was heated and pressed under conditions of 200°C and 5 MPa for 5 minutes and then heated under conditions of 200°C and atmospheric pressure for 2 hours. Thereby, the laminate was obtained.

<Evaluation of adhesiveness (adhesive strength)>

After the above treatment was performed, a 90° peel test was performed according to "adhesive-peeling adhesion strength test method" in JIS K 6854-1: 1999 using a universal testing machine (product name: RTG-1310, commercially available from A&D Co., Ltd.). Here, peeling was performed at the adhesive interface between the sheet-like copper foil and the composite sheet. Measurement was performed under conditions of a test speed of 50 mm/min, a load cell of 5 kN, and a measurement temperature of room temperature (20°C), the area proportion of the cohesive fracture part on the peeled surface was measured. Based on the measurement results, the adhesiveness was evaluated according to the following criteria. The results are shown in Table 1. Here, the cohesive fracture part was an area of the part in which the composite sheet was fractured, and a higher area proportion indicates better adhesiveness.

A: the area proportion of the cohesive fracture part was 70 area% or more.
B: the area proportion of the cohesive fracture part was 50 area% or more and less than 70 area%.
C: the area proportion of the cohesive fracture part was less than 50 area%.

(Example 2)

A composite sheet and a laminate were produced in the same manner as in Example 1 except that the heating time of the resin composition was changed to 11 hours.

(Example 3)

A composite sheet and a laminate were produced in the same manner as in Example 1 except that a sintered boron nitride component having a thickness and an average pore size shown in Table 1 was used as the sintered ceramic component and the heating time of the resin composition was changed to 11 hours.

(Comparative Example 1)

A composite sheet and a laminate were produced in the same manner as in Example 1 except that the heating time of the resin composition was changed to 3 hours.

(Comparative Example 2)

A composite sheet and a laminate were produced in the same manner as in Example 1 except that the heating

time of the resin composition was changed to 14 hours.

(Comparative Example 3)

A composite sheet and a laminate were produced in the same manner as in Example 1 except that a sintered boron nitride component having a thickness and an average pore size shown in Table 1 was used as the sintered ceramic component.

For the composite sheets and laminates obtained in Examples 2 to 3 and Comparative Examples 1 to 3, in the same manner as in Example 1, the content of triazine rings in the resin (semi-cured product), the infrared absorption intensity corresponding to the triazine rings, the resin filling rate and the adhesive strength were evaluated. The results are shown in Table 1.

[Table 1]

| | Production condi ions | | | | | Composite sheet | | | Evaluation |
|---|---|---|---|---|---|---|---|---|---|
| | Sintered ceramic component | | Resin composition | Curing conditions of resin composition | | Content of triazine rings in resin [mass%] | [peat intensity at 1,533 to 1,565 $cm^{-1}$]/[peak intensity at 1,498 to 1.526 $cm^{-1}$] | Filling rate [volume%] | Adhesiveness |
| | Thickness t [mm] | Average pore size [μm] | Content of curing agent (parts by mass] | Heating temperature [°C] | Heating time [hr] | | | | |
| Example 1 | 0.31 | 3.3 | 0.5 | 120 | 5.0 | 0.65 | 0.240 | 95.2 | A |
| Example 2 | 0.31 | 3.3 | 0.5 | 120 | 11.0 | 3.61 | 0.743 | 92.1 | A |
| Example 3 | 1.82 | 3.3 | 0.5 | 120 | 11.0 | 3.49 | 0.741 | 89.2 | B |
| Comparative Example 1 | 0.31 | 3.3 | 0.5 | 120 | 3.0 | 0.07 | 0.079 | 97.2 | C |
| Comparative Example 2 | 0.31 | 3.3 | 0.5 | 120 | 14.0 | 4.60 | 0.981 | 84.1 | C |
| Comparative Example 3 | 23.20 | 3.3 | 0.5 | 120 | 5.0 | 1.20 | 0.245 | 82.5 | C |

According to the present disclosure, it is possible to provide a composite sheet that can be easily miniaturized and has excellent adhesiveness. According to the present disclosure, it is possible to provide a laminate that has excellent adhesiveness even when miniaturized using such a composite sheet. According to the present disclosure, it is possible to provide an evaluation method for estimating adhesiveness of a composite sheet.

## Reference Signs List

10 Composite sheet
10a, 10b Main surface
20 Sintered ceramic component
30, 40 Metal sheet
100 Laminate

## Claims

1. A composite sheet, comprising:

   a porous sintered ceramic component having a thickness of less than 2 mm; and
   a resin filled into pores of the sintered ceramic component,
   wherein the resin is a semi-cured product of a resin composition comprising a compound having a cyanate group, and
   wherein the content of triazine rings in the resin is 0.6 to 4.0 mass%.

2. A composite sheet, comprising:

   a porous sintered ceramic component having a thickness of less than 2 mm; and
   a resin filled into pores of the sintered ceramic component,
   wherein the resin is a semi-cured product of a resin composition comprising a compound having a cyanate group, and
   wherein, when an infrared absorption intensity corresponding to the resin is measured by an ATR method, the value obtained by dividing a peak intensity at 1,533 to 1,565 $cm^{-1}$ corresponding to a triazine ring by a peak intensity at 1,498 to 1,526 $cm^{-1}$ is 0.200 to 0.800.

3. The composite sheet according to claim 1 or 2,
   wherein the filling rate of the resin is 85 volume% or more.

4. A laminate in which the composite sheet according to any one of claims 1 to 3 and a metal sheet are laminated.

5. An evaluation method for estimating adhesiveness of a composite sheet comprising a porous sintered ceramic component having a thickness of less than 2 mm and a resin filled into pores of the sintered ceramic component, the method comprising:

   a step of measuring an infrared absorption intensity of the resin by an ATR method; and
   a step of estimating the adhesiveness of the composite sheet using the value of the infrared absorption intensity.

*Fig.1*

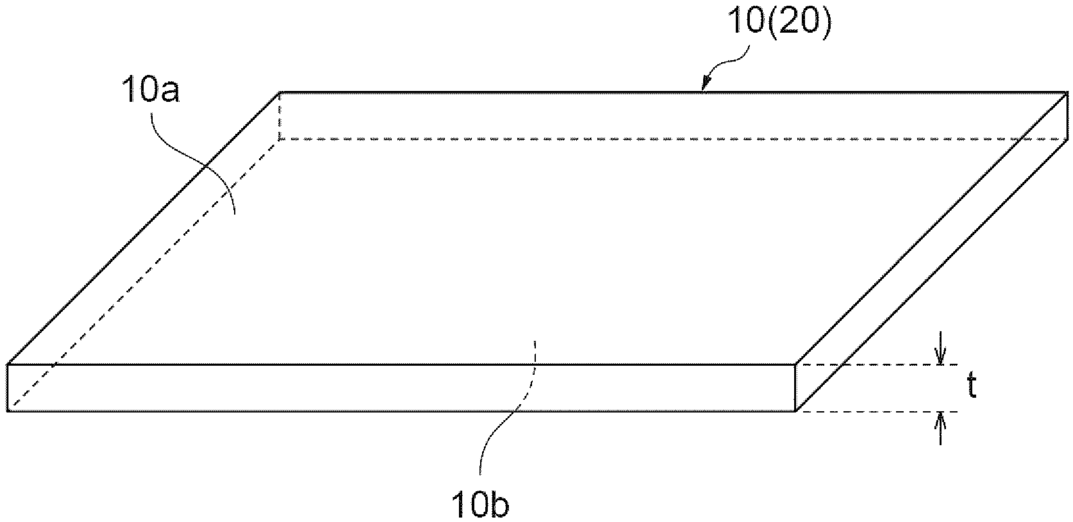

*Fig.2*

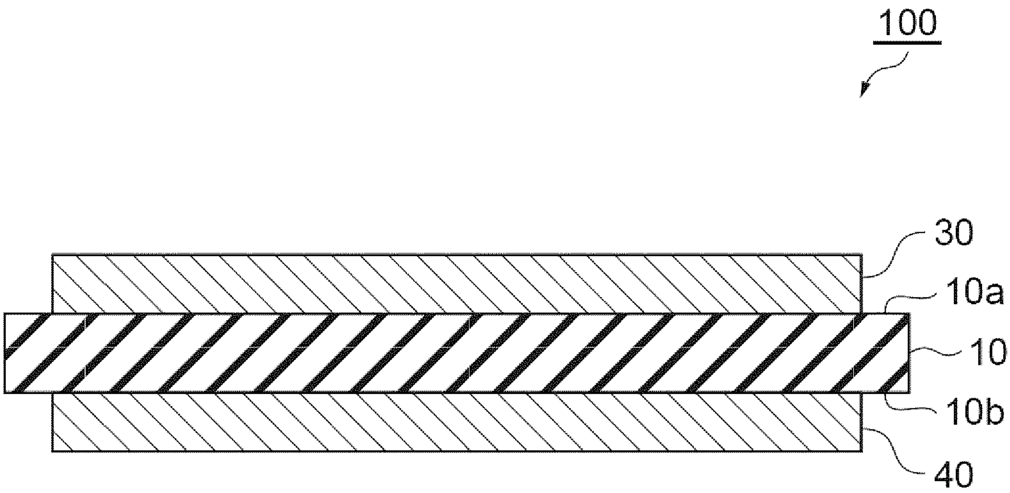

## INTERNATIONAL SEARCH REPORT

International application No.
**PCT/JP2021/035601**

**A. CLASSIFICATION OF SUBJECT MATTER**

***H01L 23/15***(2006.01)i; ***B32B 5/18***(2006.01)i; ***B32B 9/00***(2006.01)i; ***B32B 9/04***(2006.01)i; ***B32B 15/04***(2006.01)i; ***B32B 27/04***(2006.01)i; ***C04B 35/5835***(2006.01)i; ***C04B 38/00***(2006.01)i; ***C04B 41/83***(2006.01)i; ***H01L 23/12***(2006.01)i; ***H01L 23/14***(2006.01)i

FI: H01L23/14 C; B32B5/18; B32B9/00 A; B32B9/04; B32B15/04 Z; B32B27/04 Z; C04B35/5835; C04B38/00 303Z; C04B41/83 G; H01L23/12 J; H01L23/14 R

According to International Patent Classification (IPC) or to both national classification and IPC

**B. FIELDS SEARCHED**

Minimum documentation searched (classification system followed by classification symbols)

H01L23/15; B32B5/18; B32B9/00; B32B9/04; B32B15/04; B32B27/04; C04B35/5835; C04B38/00; C04B41/83; H01L23/12; H01L23/14

Documentation searched other than minimum documentation to the extent that such documents are included in the fields searched

Published examined utility model applications of Japan 1922-1996
Published unexamined utility model applications of Japan 1971-2021
Registered utility model specifications of Japan 1996-2021
Published registered utility model applications of Japan 1994-2021

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| A | WO 2019/111978 A1 (DENKA COMPANY LTD) 13 June 2019 (2019-06-13) entire text | 1-5 |
| A | JP 2016-103611 A (DENKA CO LTD) 02 June 2016 (2016-06-02) entire text, all drawings | 1-5 |
| A | JP 2013-251427 A (TORAY IND INC) 12 December 2013 (2013-12-12) entire text | 1-5 |
| P, A | WO 2021/079918 A1 (DENKA COMPANY LTD) 29 April 2021 (2021-04-29) entire text, all drawings | 1-5 |

☐ Further documents are listed in the continuation of Box C. ☑ See patent family annex.

* Special categories of cited documents:
- "A" document defining the general state of the art which is not considered to be of particular relevance
- "E" earlier application or patent but published on or after the international filing date
- "L" document which may throw doubts on priority claim(s) or which is cited to establish the publication date of another citation or other special reason (as specified)
- "O" document referring to an oral disclosure, use, exhibition or other means
- "P" document published prior to the international filing date but later than the priority date claimed
- "T" later document published after the international filing date or priority date and not in conflict with the application but cited to understand the principle or theory underlying the invention
- "X" document of particular relevance; the claimed invention cannot be considered novel or cannot be considered to involve an inventive step when the document is taken alone
- "Y" document of particular relevance; the claimed invention cannot be considered to involve an inventive step when the document is combined with one or more other such documents, such combination being obvious to a person skilled in the art
- "&" document member of the same patent family

| Date of the actual completion of the international search | Date of mailing of the international search report |
|---|---|
| **01 December 2021** | **14 December 2021** |
| Name and mailing address of the ISA/JP<br>**Japan Patent Office (ISA/JP)**<br>**3-4-3 Kasumigaseki, Chiyoda-ku, Tokyo 100-8915**<br>**Japan** | Authorized officer<br><br>Telephone No. |

Form PCT/ISA/210 (second sheet) (January 2015)

**INTERNATIONAL SEARCH REPORT**
**Information on patent family members**

International application No.
**PCT/JP2021/035601**

| Patent document cited in search report | Publication date (day/month/year) | Patent family member(s) | Publication date (day/month/year) |
|---|---|---|---|
| WO 2019/111978 A1 | 13 June 2019 | US 2021/0032171 A1<br>entire text<br>EP 3722368 A1<br>CN 111372996 A<br>KR 10-2020-0090166 A | |
| JP 2016-103611 A | 02 June 2016 | (Family: none) | |
| JP 2013-251427 A | 12 December 2013 | (Family: none) | |
| WO 2021/079918 A1 | 29 April 2021 | (Family: none) | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- WO 2014196496 A
- JP 2016103611 A